# FASCICULE DE BREVET EUROPEEN

(11) **EP 1 183 643 B1**
(45) Date de publication et mention de la délivrance du brevet: **05.03.2008**
(21) Numéro de dépôt: 00985344.1
(22) Date de dépôt: 28.11.2000
(51) Int. Cl.: G06K 19/077

(54) **PROCEDE DE FABRICATION D'UNE CARTE A PUCE SANS CONTACT AVEC UN SUPPORT D'ANTENNE EN MATERIAU FIBREUX**
VERFAHREN ZUR HERSTELLUNG EINER KONTAKTLOSEN CHIPKARTE MIT EINEM ANTENNENTRÄGER AUS FASERMATERIAL
METHOD FOR MAKING A NON-CONTACT SMART CARD WITH AN ANTENNA SUPPORT MADE OF FIBROUS MATERIAL

(30) Priorité: 29.11.1999 FR 9915019
(43) Date de publication de la demande: 06.03.2002
(73) Titulaire: ASK S.A., 06560 Valbonne (FR)
(72) Inventeur: KAYANAKIS, Georges, F-06000 Antibes (FR); MATHIEU, Christophe, F-27950 Saint-Marcel (FR); DELENNE, Sébastien, F-13530 Trets (FR)
(86) Numéro de dépôt international: PCT/FR2000/003321
(87) Numéro de publication internationale: WO 2001/041060

(56) Documents cités:
- FR-A- 615 285
- FR-A- 2 769 440
- US-A- 5 495 250
- US-A- 5 969 951

## Description

### Domaine technique:

La présente invention concerne les procédés de fabrication de cartes à puce, et plus particulièrement un procédé de fabrication d'une carte à puce sans contact dont l'antenne est sur un support en matériau fibreux tel que le papier.

### Etat de la technique :

La carte à puce sans contact est un système de plus en plus utilisé dans différents secteurs. Ainsi, dans le secteur des transports, elle a été développée comme moyen de paiement. C'est le cas également du porte-monnaie électronique. De nombreuses sociétés ont également développé des moyens d'identification de leur personnel par cartes à puce sans contact.

L'échange d'informations entre une carte sans contact et le dispositif de lecture associé s'effectue par couplage électromagnétique à distance entre une antenne logée dans la carte sans contact et une deuxième antenne située dans le lecteur. Pour élaborer, stocker et traiter les informations, la carte est munie d'une puce qui est reliée à l'antenne. L'antenne et la puce se trouvent généralement sur un support diélectrique en matière plastique. Leur procédé de fabrication industrielle classique se décompose en trois étapes :
- réalisation de l'antenne sur un support diélectrique plastique (polychlorure de vinyle (PVC), polyesters (PET), polycarbonate (PC)...) par gravure chimique du cuivre ou de l'aluminium,
- connexion des plots de contact de la puce sur les plots de contact de l'antenne à l'aide d'encre ou d'époxy ou de polymères conducteurs, appelée communément technique de report « flip-chip ».
- lamination sous pression à chaud des couches plastiques inférieure et supérieure du corps de carte (PVC, PET, PC, acrylonitrile-butadiène-styrène (ABS)...), sur le support de l'antenne afin de former une carte monobloc.

Toutefois, ce procédé engendre plusieurs inconvénients majeurs. En effet, il conduit à un empilage composite de matériaux plastiques collés ou thermosoudés avec des coefficients de dilatation thermique différents. Par conséquent, on observe systématiquement des déformations irréversibles des cartes (vrillage, gauchissement) inacceptables par l'utilisateur, ainsi qu'un manque de tenue mécanique lors de l'application d'essais normalisés ou équivalents.

De plus, les propriétés thermomécaniques du PVC sont médiocres. Lors de la lamination, le fluage de matière est très important et le facteur de forme de l'antenne n'est pas conservé. Cela entraîne un dysfonctionnement de l'antenne car les paramètres électriques (inductance et résistance) varient. Il n'est pas rare d'observer des coupures d'antenne aux endroits où les contraintes de cisaillement sont fortes. C'est le cas notamment dans les angles ou au niveau des pontages électriques.

L'épaisseur totale des cartes ISO laminées varie entre 780 et 840 µm. Compte tenu des flux de matière décrits précédemment, il est également très difficile de garantir aux clients une distribution étroite et contrôlée de la population.

La thermosoudure plastique mise en oeuvre au moment de la lamination conduit à une carte monobloc dont les propriétés mécaniques sont médiocres en terme de restitution des contraintes absorbées : lors des tests normalisés de flexion et de torsion, la totalité de la contrainte imposée est transmise à la puce et plus particulièrement aux points de colle assurant les connexions. La tenue mécanique des joints de colle est soumise à rude épreuve et la moindre imperfection de l'opération de report de la puce sur l'antenne (technique de report « flip-chip ») se traduit par une rupture de la connexion électrique puce - antenne.

Après lamination, l'empreinte des pistes de cuivre est visible sur les corps de carte imprimés. Sans conséquence pour le bon fonctionnement de la carte, ce défaut est très souvent mis en avant par les utilisateurs très sensibles aux critères esthétiques. De plus, les coûts de fabrication de carte par ce procédé sont trop élevés pour permettre un réel accroissement de leur utilisation.

Le document FR 2 769 440 décrit une carte à puce composée de plusieurs couches dont une couche peut être en matière fibreuse mais il s'agit d'une couche externe située à l'extérieur de l'empilement des couches, dite couche de décoration apte à recevoir une impression.

Les procédés actuellement utilisés ne permettent pas d'obtenir des cartes donnant la possibilité de visualiser a posteriori les mauvais traitements mécaniques qui leur sont infligés par les utilisateurs, notamment dans le but de frauder. En effet, il est relativement aisé pour un fraudeur averti de détruire la carte par pliages intensifs répétés sans que l'on puisse facilement prouver a posteriori l'intention de nuire. Par exemple, l'antenne peut être coupée sans que la carte soit marquée. Les politiques commerciales mises alors en place par les sociétés consistent généralement à remplacer gratuitement les cartes défectueuses. Le remplacement systématique de ces cartes génère des coûts supplémentaires importants pour ces sociétés.

### Exposé de l'invention :

Le but de l'invention est de pallier à ces inconvénients en fournissant un procédé de fabrication inventif permettant d'utiliser un support en matière fibreuse sur lequel est réalisée l'antenne par sérigraphie d'encre conductrice, ce qui permet de diminuer fortement les coûts de production des cartes à puce sans contact ou hybrides.

L'invention concerne donc un procédé de fabrication selon la revendication 1.

### Description brève des figures :

Les buts, objets et caractéristiques ressortiront mieux à la lecture de la description qui suit faite en référence aux dessins joints dans lesquels :
Les figures 1A à 1C représentent les différentes étapes de la sérigraphie de l'antenne sur le support.
La figure 2 représente le support avec l'antenne sérigraphiée avant l'étape de lamination.
La figure 3 représente la carte à puce à la fin du procédé de fabrication.
La figure 4 représente une coupe transversale de la carte à puce, représentée sur la figure 3, selon l'axe A-A de la figure 3.

### Description détaillée de l'invention :

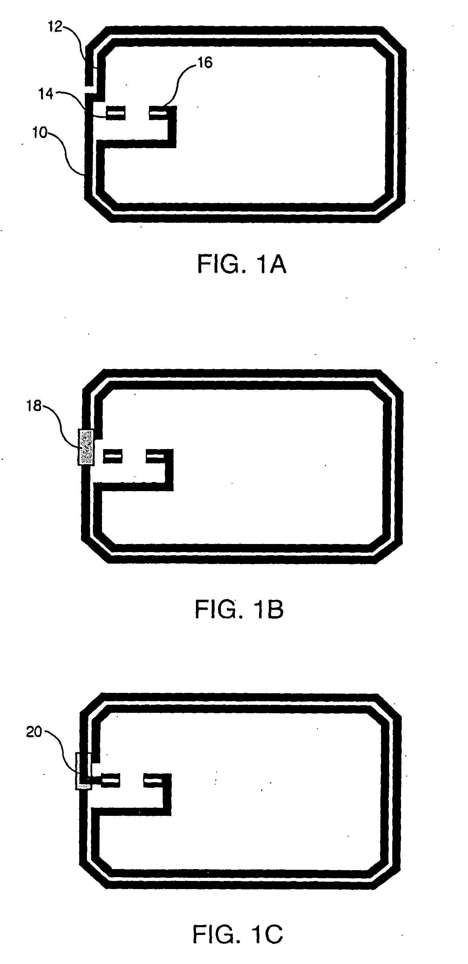

Le procédé de fabrication de la carte à puce selon l'invention consiste tout d'abord à réaliser l'antenne sur un support. Ce support est réalisé sur une feuille de matériau fibreux tel que le papier. Selon un mode préféré de réalisation, l'antenne est sérigraphiée sur ce matériau en plusieurs étapes. La première étape, représentée à la figure 1A, consiste à sérigraphier les deux spires 10 et 12 et les deux plots de connexions de l'antenne 14 et 16. La deuxième étape, représentée à la figure 1B consiste à sérigraphier une bande isolante 18 pour permettre le croisement des spires 10 et 12 sans contact électrique. La troisième étape, représentée à la figure 1C, consiste à sérigraphier le pont électrique 20 permettant de connecter la spire 10 au plot de connexion 14.

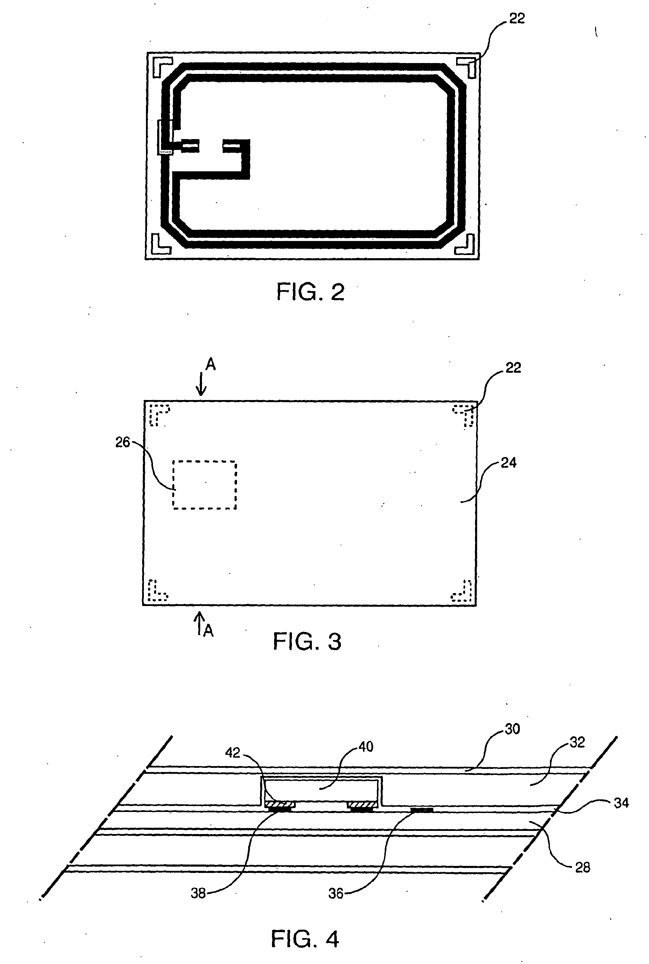

Une fois l'antenne sérigraphiée sur le support, celui-ci est découpé aux dimensions de la carte. Selon un mode de réalisation préféré, on réalise alors une découpe 22 dans chaque coin du support, telle que représentée à la figure 2. Cette découpe permet une soudure directe entre les corps de carte lors de l'étape de lamination.

La lamination se fait par pressage à chaud. Selon un mode de réalisation préféré, on utilise pour chaque corps de carte deux couches de matière plastique. Cette matière plastique est généralement du polychlorure de vinyle (PVC), du polyester (PET, PETG), du polycarbonate (PC) ou de l'acrylonitrile-butadiène-styrène (ABS). Selon un mode de réalisation préféré, on utilise du PVC. Les deux couches sont de rigidité différente. En effet, la couche externe est en PVC rigide, alors que la couche interne (en contact avec le support de l'antenne) est en PVC mou avec un point Vicat inférieur (température à partir de laquelle le PVC passe d'un état rigide à un état caoutchouteux). Les deux couches peuvent également être d'épaisseur différente. Par exemple, chacun des corps de carte est constitué d'une couche externe de PVC rigide d'environ 310 microns (µm) et d'une couche interne de PVC mou d'environ 80 µm. Le support de l'antenne est en papier et a une épaisseur d'environ 125 µm. Selon un autre exemple de réalisation, qui est un mode réalisation préféré, chacun des corps de carte est constitué de trois couches. En effet, une couverture, constituée d'une feuille en PVC transparent ou d'une couche de vernis, est ajoutée sur la couche externe des corps de carte lorsque celle-ci est imprimée pour protéger cette impression. Cette couverture a une épaisseur d'environ 40 µm, la couche externe du corps de carte a alors une épaisseur d'environ 275 µm et la couche interne une épaisseur d'environ 40 µm.

L'étape de lamination consiste à empiler les différentes couches de PVC constituant les corps de carte et le support d'antenne. Ce sandwich est ensuite placé dans une presse à laminer. Le sandwich subit alors un traitement thermique à une température supérieure à 100 °C mais préférentiellement supérieure à 150 °C. En même temps, le sandwich subit un pressage afin de souder les différentes couches. Sous l'action combinée de la chaleur et de la pression, la couche externe de PVC se ramollit, alors que la couche interne constituée d'un PVC de point Vicat plus bas se fluidifie. Le PVC ainsi fluidifié vient emprisonner l'encre sérigraphiée de l'antenne dans la masse, ce qui permet à cette dernière d'avoir une meilleure résistance aux contraintes mécaniques lors de l'utilisation de la carte à puce. De plus, l'adhérence de l'antenne sur les corps de carte est meilleure. Cette adhérence peut encore être améliorée par l'utilisation d'un adhésif double face sensible à la pression, placé entre les corps de carte et l'antenne.

Les découpes 22 réalisées dans les coins du support d'antenne permettent aux deux couches interne de PVC d'être en contact l'une avec l'autre. En bloquant les coins par soudure entre les deux corps de carte, toutes les contraintes mécaniques sont transmises à l'intérieur de la carte. Or, dans le cas du papier, la pâte à papier possède une faible cohésion interne. Lorsqu'elle est soumise à des contraintes de cisaillement, l'âme du papier a tendance à se délaminer. Si ces contraintes sont trop fortes, la carte s'ouvre jusqu'à la séparation en deux parties (la partie qui contient l'antenne connectée au module continue de fonctionner). Ainsi, en jouant sur la nature du papier et sur sa cohésion interne, on peut mettre à profit cette propriété physique pour créer une carte avec marqueur de contraintes modulable et intégré. Ainsi, selon les besoins du client, la délamination peut être plus ou moins rapide et plus ou moins importante, de manière à ce qu'une flexion limitée de la carte puisse être visualisée par une délamination du papier à l'intérieur de celle-ci.

Une fois cette étape achevée, on obtient une carte telle que représentée à la figure 3. Les corps de carte 24 sont thermosoudés entre eux dans les coins, là où on été réalisées les découpes 22 sur le support d'antenne. La puce 26 est noyée dans la carte et n'est donc pas visible.

La figure 4 est une vue en coupe transversale selon l'axe A-A de la carte à puce représentée à la figure 3. La carte est constituée du support d'antenne 28 en matériau fibreux, inséré entre les deux corps de carte. Chaque corps de carte comprend une couverture 30, constituée d'une feuille de PVC transparent ou d'une couche de vernis, une couche externe de PVC rigide 32 et une couche interne de PVC mou 34. La spire 36 et les plots de connexion 38 sont emprisonnés dans la masse du PVC de la couche interne 34 du corps de carte. La puce 40 est connectée aux plots de l'antenne 38 par une couche de colle conductrice 42. Cette colle conductrice est à base d'encre, d'époxy ou de polymères conducteurs. Selon un mode de réalisation particulier, le collage est effectué selon la technique communément appelée technique de report « flip-chip ».

Le procédé selon l'invention permet d'obtenir une carte qui possède deux qualités majeures pour les sociétés qui l'utilisent : la préservation des composantes électriques confère à cette carte une solidité plus importante et la propriété de délamination des matériaux fibreux tels que le papier permet, en cas de panne de la carte, de vérifier que la carte n'a pas subi de pliages intensifs dans le but de frauder.

## Revendications

1. Procédé de fabrication d'une carte à puce sans contact avec un support (28) d'antenne en matière fibreuse tel que le papier comprenant les étapes suivantes :
une étape de fabrication de l'antenne consistant à sérigraphier des spires (10, 12 ou 36) d'encre polymère conductrice sur un support en matière fibreuse et à faire subir un traitement thermique audit support afin de cuire ladite encre, **caractérisé en ce que** le procédé comprend en outre :
une étape de collage avec une colle conductrice (42) des plots de contact de la puce (40) sur les plots de contact (14, 16 ou 38) de l'antenne, et
une étape de lamination des corps de carte sur le support de l'antenne consistant à souder de chaque côté dudit support au moins deux feuilles en matière plastique de rigidité différente la matière plastique constituant la couche externe (32) des corps de carte étant plus rigide que la matière plastique constituant la couche interne (34) des corps de carte, par pressage à chaud.

2. Procédé de fabrication d'une carte à puce selon la revendication 1, dans lequel, durant l'étape de fabrication de l'antenne, les coins du support d'antenne en papier sont découpés afin de permettre la soudure entre les deux corps de carte, ladite carte ainsi obtenue offrant ainsi une zone préférentielle de délamination, permettant de mettre en évidence a posteriori un acte de dégradation volontaire.

3. Procédé de fabrication d'une carte à puce selon la revendication 2, **caractérisé en ce que** ladite couche interne des corps de carte posséde un point Vicat inférieure à celui de la couche externe des corps de carte.

4. Procédé de fabrication d'une carte à puce selon l'une des revendications précédentes, dans lequel les deux feuilles constituant chacun des corps de carte sont d'épaisseur différente.

5. Procédé de fabrication d'une carte à puce selon la revendication 4, dans lequel la feuille constituant la couche externe (32) est plus épaisse que la feuille constituant la couche interne (34).

6. Procédé de fabrication d'une carte à puce selon l'une des revendication précédentes, dans lequel durant l'étape de lamination des corps de carte à chaud sur le support de l'antenne, on ajoute une troisième feuille (30) en matière plastique ou une couche de vernis à chaque corps de carte, jouant le rôle de couverture.

7. Procédé de fabrication d'une carte à puce selon l'une des revendications précédentes, dans lequel la matière plastique constituant les corps de carte est le polychlorure de vinyle (PVC), du polyester (PET, PETG), du polycarbonate (PC) ou de l'acrylonitrile-butadiène-styrène (ABS).

8. Procédé de fabrication d'une carte à puce selon l'une des revendications précédentes, dans lequel la colle conductrice (42) permettant de coller les plots de contact de la puce sur les plots de contact de l'antenne est à base d'encre, d'époxy ou de polymères conducteurs.

## Claims

1. A manufacturing process of a contactless smart card with an antenna support (28) made of fibrous material such as paper, comprised of the following steps:
a manufacturing process of the antenna consisting in screen printing turns (10, 12 or 36) of electrically conductive polymer ink on a support made of fibrous materials and to subject said support to a heat treatment in order to bake said ink,
**characterized in that** the process comprising:
a bonding step using electrically conductive adhesive (42) to bond the chip's bonding pads (40) onto the antenna's bonding pads (14, 16 or 38), and
a step which laminates the card bodies onto the antenna support consisting in welding each side of said support to at least two sheets made of plastic material having different stiffness, the plastic material forming the external layer (32) of the card body is stiffer than the plastic material forming the internal layer (34) of the card body, by a hot press molding process.

2. The smart card manufacturing process according to claim 1, in which, during the antenna manufacturing process, the corners of the paper antenna support are notched in order to allow the two card bodies to be welded together; said card obtained thereby offering a preferential delamination zone which' will highlight any act of deliberate damage a posteriori.

3. The smart card manufacturing process according to claim 2, **characterized in that**, said internal layer having a lower Vicat softening temperature than the internal layer of the card body.

4. A smart card manufacturing process, according to one of the previous claims, in which the two sheets each forming card bodies are of different thickness.

5. A smart card manufacturing process according to claim 4, in which the sheet forming the external layer (32) is thicker that the sheet forming the internal layer (34).

6. A process for manufacturing a smart card according to one of the previous claims, in which, during the hot lamination step of the card bodies onto the antenna support, a third sheet (30) of plastic material or varnish layer is added to each card body which acts as a cover.

7. A smart card manufacturing process according to one of the previous claims, in which the plastic material forming the card bodies is polyvinyl chloride (PVC), polyester (PET, PETG), polycarbonate (PC) or acrylonitrile-butadiene-styrene (ABS).

8. A smart card manufacturing process according to one of the previous claims, in which the conductive glue (42) used to bond the bonding pads of the chip onto the bonding pads of the antenna is electrically conductive ink, epoxy or polymer based.

## Patentansprüche

1. Verfahren zur Herstellung einer kontaktlosen Chipkarte mit einem Antennenträger (28) aus Fasermaterial wie Papier, das die folgenden Schritte aufweist:
einen Schritt der Herstellung der Antenne, der darin besteht, durch Siebdruck Windungen (10, 12 oder 36) aus leitender Polymerdruckfarbe auf einen Träger aus Fasermaterial aufzubringen und einer Wärmebehandlung zu unterziehen, um die Druckfarbe zu härten,
**dadurch gekennzeichnet, dass** das Verfahren außerdem aufweist:
einen Schritt des Klebens mit einem leitenden Klebstoff (42) der Kontaktstücke des Chips (40) auf die Kontaktstücke (14, 16 oder 38) der Antenne, und
einen Schritt des Walzens der Kartenkörper auf den Antennenträger, der darin besteht, auf jede Seite des Trägers mindestens zwei Folien aus Kunststoff mit unterschiedlicher Steifheit zu schweißen, wobei der die Außenschicht (32) der Kartenkörper bildende Kunststoff steifer ist als der Kunststoff, der die Innenschicht (34) der Kartenkörper bildet, durch Warmpressen.

2. Verfahren zur Herstellung einer Chipkarte nach Anspruch 1, bei dem während des Schritts der Herstellung der Antenne die Ecken des Antennenträgers aus Papier abgeschnitten werden, um das Schweißen zwischen den zwei Kartenkörpern zu ermöglichen, wodurch die so erhaltene Karte eine bevorzugte Aufblätterzone bietet, die es ermöglicht, nachträglich einen Akt der absichtlichen Beschädigung aufzuzeigen.

3. Verfahren zur Herstellung einer Chipkarte nach Anspruch 2, **dadurch gekennzeichnet, dass** die Innenschicht der Kartenkörper einen Vicat-Punkt aufweist, der niedriger ist als derjenige der Außenschicht der Kartenkörper.

4. Verfahren zur Herstellung einer Chipkarte nach einem der vorhergehenden Ansprüche, bei dem die zwei jeden der Kartenkörper bildenden Folien eine unterschiedliche Dicke haben.

5. Verfahren zur Herstellung einer Chipkarte nach Anspruch 4, bei dem die die Außenschicht (32) bildende Folie dicker ist als die die Innenschicht (34) bildende Folie.

6. Verfahren zur Herstellung einer Chipkarte nach einem der vorhergehenden Ansprüche, bei dem während des Schritts des Warmwalzens der Kartenkörper auf dem Antennenträger jedem Kartenkörper eine dritte Folie (30) aus Kunststoff oder eine Lackschicht hinzugefügt wird, die die Aufgabe einer Abdeckung hat.

7. Verfahren zur Herstellung einer Chipkarte nach einem der vorhergehenden Ansprüche, bei dem der die Kartenkörper bildende Kunststoff Polyvinylchlorid (PVC), Polyester (PET, PETG), Polycarbonat (PC) oder Acrylnitril-Butadien-Styrol (ABS) ist.

8. Verfahren zur Herstellung einer Chipkarte nach einem der vorhergehenden Ansprüche, bei dem der leitende Klebstoff (42), der es ermöglicht, die Kontaktstücke des Chips auf die Kontaktstücke der Antenne zu kleben, auf der Basis von Druckfarbe, Epoxid oder leitenden Polymeren ist.
